(19) **Europäisches Patentamt**

**European Patent Office**

**Office européen des brevets**

(11) **EP 0 809 292 B1**

(12) **EUROPEAN PATENT SPECIFICATION**

(45) Date of publication and mention
of the grant of the patent:
**31.07.2002 Bulletin 2002/31**

(51) Int Cl.[7]: **H01L 25/18**, H01L 25/07

(21) Application number: **97112462.3**

(22) Date of filing: **21.04.1994**

(54) **Power transistor module**

Leistungstransistormodul

Module de transistor à puissance

(84) Designated Contracting States:
**DE FR GB**

(30) Priority: **23.04.1993 JP 9743493**
 **27.07.1993 JP 18426793**
 **28.10.1993 JP 26935393**

(43) Date of publication of application:
**26.11.1997 Bulletin 1997/48**

(62) Document number(s) of the earlier application(s) in
accordance with Art. 76 EPC:
**94106178.0 / 0 621 635**

(73) Proprietor: **FUJI ELECTRIC CO. LTD.**
**Kawasaki 210 (JP)**

(72) Inventors:
 • **Yamada, Toshifusa**
 **Kawasaki-ku, Kawasaki 210 (JP)**
 • **Soyano, Shin**
 **Kawasaki-ku, Kawasaki 210 (JP)**
 • **Arai, Etsuo**
 **Kawasaki-ku, Kawasaki 210 (JP)**
 • **Watanabe, Manabu**
 **Kawasaki-ku, Kawasaki 210 (JP)**
 • **Igarashi, Seiki**
 **Kawasaki-ku, Kawasaki 210 (JP)**

(74) Representative: **Hoffmann, Eckart, Dipl.-Ing.**
 **Patentanwalt,**
 **Bahnhofstrasse 103**
 **82166 Gräfelfing (DE)**

(56) References cited:
**EP-A- 0 427 143**    **EP-A- 0 455 322**
**EP-A- 0 527 033**    **DE-A- 3 336 979**
**DE-A- 3 516 995**    **DE-U- 9 203 000**
**US-A- 4 920 405**

**Description**

The present invention relates to a power transistor module for use in a power switching device, and more particularly to its internal wiring structure.

Recently, products with power transistor modules which have a bridge circuit construction with a number of transistor chips assembled in the same package with connections between the transistors are widely available on the market. IGBT's (Insulated Gate Bipolar Transistors) are used as the power switching elements, for example.

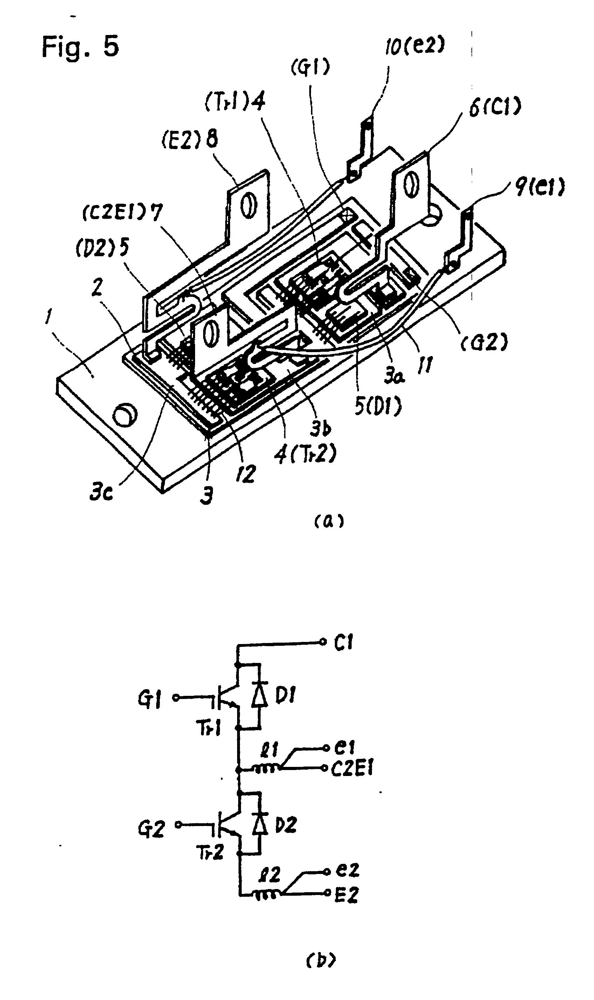

FIG. 5(a) and (b) are views of a prior art module construction using a half-bridge structure with two power transistor chips. In FIG. 5(a), the numeral 1 indicates a metal base for heat dissipation, numeral 2 indicates an insulating substrate for the circuit, numeral 3 indicates a copper foil circuit pattern formed on the insulating substrate, numeral 4 indicates a power transistor chip such as an IGBT chip (hereinafter referred to as "transistor"), numeral 5 indicates a free-wheel diode chip connected in antiparallel with the transistor 4 (hereinafter referred to as "free-wheel diode" or simply "diode"), numerals 6, 7 and 8 indicate external connection terminals for connecting the module to a main circuit, numerals 9 and 10 indicate auxiliary terminals taken out from the emitter of each transistor, numeral 11 indicates an internal lead connecting the auxiliary terminals 9 and 10 to the external connection terminals 7 and 8, respectively, and numeral 12 indicates bonding wires connecting the electrodes of transistors 4 and diodes 5 to the circuit pattern 3.

A circuit substrate such as a DBC substrate (Direct Bonding Copper substrate) or an insulated aluminum substrate may be adopted as the circuit substrate. The signs indicated in brackets in FIG. 5(a) correspond to the signs for each of the elements and terminals in the equivalent circuit in FIG. 5(b). Here, Tr1 and Tr2 indicate the power transistors for the upper and lower arms, D1 and D2 indicate the free-wheel diodes, C1 indicates the collector terminal for the transistor Tr1, C2E1 indicates the common terminal for the emitter of the transistor Tr1 and the collector of the transistor Tr2, E2 indicates the emitter terminal for the transistor Tr2, e1 and e2 indicate auxiliary emitter terminals for the transistors Tr1 and Tr2 and G1 and G2 indicate the gate terminals.

In the construction of FIG. 5, the external connection terminal 6 is taken out from a collector pattern part 3a of the circuit pattern 3, on which the transistor Tr1 and the diode D1 are mounted, and the external connection terminal 7 is taken out from a collector pattern part 3b on which the transistor Tr2 and the diode D2 are mounted. Bonding wires 12 connect the pattern part 3b to the emitter electrode of the transistor Tr1 and the anode of the diode D1. Also, bonding wires 12 connect the pattern part 3c to the emitter electrode of the transistor Tr2 and the anode of the diode D2. The external connection terminal 8 (E2) is taken out from an emitter pattern part 3c for the transistor Tr2. Further, the auxiliary terminals 9(e1) and 10(e2) are connected via leads 11 to terminal plates forming the respective external connection terminals 7(C2E1) and 8(E2). Wiring inductances l1 and l2 shown in the equivalent circuit diagram in FIG. 5(b) are provided by these terminal plates between the position where the leads 11 are connected and the pattern parts 3b and 3c, respectively. Gate terminals G1 and G2 are connected via a gate pattern part connected to the gate electrodes of the transistors Tr1 and Tr2, respectively, by bonding wires.

The internal wiring inductances are provided for inducing a voltage due to the counter electromotive force at the time of turning off each transistor. By applying the induced voltage to the gate of the respective transistor, the drop in the gate voltage is weakened so that the di/dt of the output current is reduced by which a jumping up of the voltage between the gate and the emitter is suppressed. Further, it is necessary that the values for the wiring inductances l1 and l2 be adjusted to be appropriate for attaining a balanced switching operation between the transistors Tr1 and Tr2.

However, as the switching frequency is increased in accordance with the use of a high switching speed device, if the internal wiring structure of the prior art is retained without modification, the internal wiring inductance l1 connected to the auxiliary terminal e1 on the side of the transistor Tr1 causes the following detriments to the switching operation.

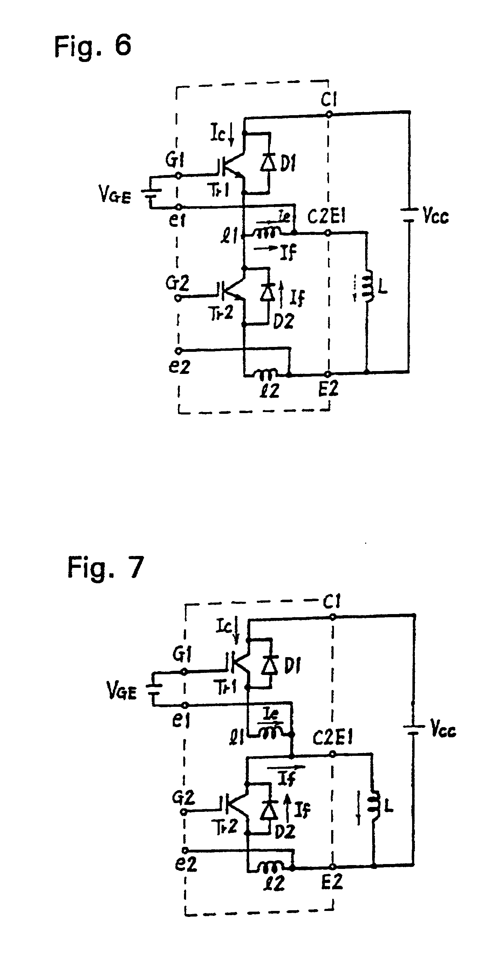

This will be described in the following with reference to FIG. 6. FIG. 6 shows the load current flow in the circuit of FIG. 5(b) during the switching operation. When transistor Tr1 is on and transistor Tr2 is off, the emitter current ie of transistor Tr1 flows to the load L via the wiring inductance l1. On the other hand, when the transistor Tr1 turns off and its collector current Ic becomes Ic=O, as a result of the free-wheeling operation of the diode D2, current If continues to flow as a free-wheeling current via the diode D2 through the wiring inductance l1 and the load L. Therefore, no sufficient counter electromotive force is induced in the wiring inductance l1 and the jumping up of the voltage explained above cannot be sufficiently suppressed. As a result malfunctioning in the transistor drive circuit and externally connected equipment to be controlled is caused.

Contrary to this, looking at the lower arm transistor Tr2, the current which flows through the wiring inductance l2 on the side of the auxiliary terminal e2 changes rapidly when the transistor Tr2 is turned on or off since there is no free-wheeling current through the wiring inductance l2. If the correspondingly high counter electromotive force induced in the wiring inductance l2 is applied to the drive circuit for the transistor Tr2 via the auxiliary terminal e2, the voltage jumping can be suppressed.

In this way, with the internal wiring structure for the power transistor module in the prior art, when carrying out high speed switching, a large jumping or surge voltage is particularly generated in the upper arm including transistor Tr1. In addition, a difference occurs between the transistor Tr1 in the upper arm and the transistor Tr2 in the lower arm with regard to the amount of the jumping voltage at the time of the switching operation. This causes unstable switching characteristics of the module.

A power transistor module is disclosed in EP-A-0 455 322 (in particular Fig. 8 of the document). In this prior art the emitter pattern part for the first transistor chip is T-shaped with the lower end of the vertical leg of the T connected to the collector pattern part for the second transistor chip. A portion of a gate pattern part for second transistor chip is arranged in the space between one part of the horizontal leg of the T and the collector pattern part for the second transistor chip. In addition, a slit is provided in collector pattern part for the second transistor chip between the portion mounting the second transistor chip and the portion to which an output terminal is connected. By this a long path for the current from the emitter electrode of the first transistor chip to this output electrode is created. An auxiliary terminal is connected to the same collector pattern part at an even greater distance from the emitter electrode of the first transistor chip.

EP-A-0 527 033 discloses a power transistor module in which one output terminal is formed integrally with a bridge shaped terminal connection member connecting the emitter pattern part of the first transistor chip and the collector pattern part of the second transistor chip. One or two additional bridge shaped internal connection members are provided between the emitter pattern part and the collector pattern part, the additional bridge shaped internal connection members having a lower inductance and a higher resistance than bridge shaped terminal connection member.

It is an object of the invention to solve the problems explained above and to provide a high power transistor module allowing a high frequency switching operation with no drastic changes in the voltage and current (dv/dt and di/dt) at the time of switching and a balanced operation of the upper and lower arms.

This object is achieved with a power transistor module according to claim 1. Preferred embodiments of the invention are subject-matter of the dependent claims.

According to the invention, a wiring inductance is connected in series between each of the transistors forming the upper and lower arms of a bridge circuit. Both, the corresponding external connection terminal and the auxiliary terminal for the first transistor are connected to portions or a portion of the wiring inductance opposite to the main electrode of the first transistor. According to this internal wiring structure, a free-wheeling current through this wiring inductance which would prevent a sufficient counter electromotive force to be induced can be avoided.

Embodiments of the invention will be explained below with reference to the diagrammatic drawings, in which:

FIG. 1    illustrates an embodiment of this invention, where FIG. 1(a) is a plan view of the internal wiring of the power transistor module, FIG. 1(b) is a side view of the structure and FIG. 1(c) is a diagram of its equivalent circuit;

FIG. 2    shows positioning marks indicating positions for the connection of the lead for connecting the emitter pattern part of the pattern in FIG. 1 to the auxiliary terminal, where FIG. 2(a) is a diagram of round pattern marks and FIG. 2(b) is a diagram of a pattern with slit shaped marks;

FIG. 3    is a view of a package construction suitable for use with the power transistor modules in each of the embodiments where FIG. 3(a) is a cut-away side view and FIG. 3(b) is a bottom view thereof;

FIG. 4    is a view of the structure of a practical example of the embodiment of this invention, where FIG. 4(a) is a plan view of the internal wiring structure and FIG. 4(b) is a diagram of the equivalent circuit;

FIG. 5    illustrates the structure of a prior art power transistor module where FIG. 5(a) is a perspective view showing the construction of the internal wiring structure for the module and FIG. 5(b) is a diagram of its equivalent circuit;

FIG. 6    is a circuit diagram for explaining the switching operation of the structure in FIG. 5;

FIG. 7    is a circuit diagram for explaining the switching operation for an embodiment of this invention; and

FIG. 8    shows the voltage and current waveforms while the power transistor module is switching, where FIG. 8(a) shows the operating waveforms for the lower arm transistor Tr2, FIG. 8(b) shows the operating waveforms for the upper arm transistor Tr1 using the construction of this invention and FIG. 8(c) shows the operating waveforms for an upper arm transistor Tr1 using the prior art construction in FIG. 5.

Parts in each of the figures which correspond to parts shown and explained above with respect to FIG. 5 are given the same reference signs.

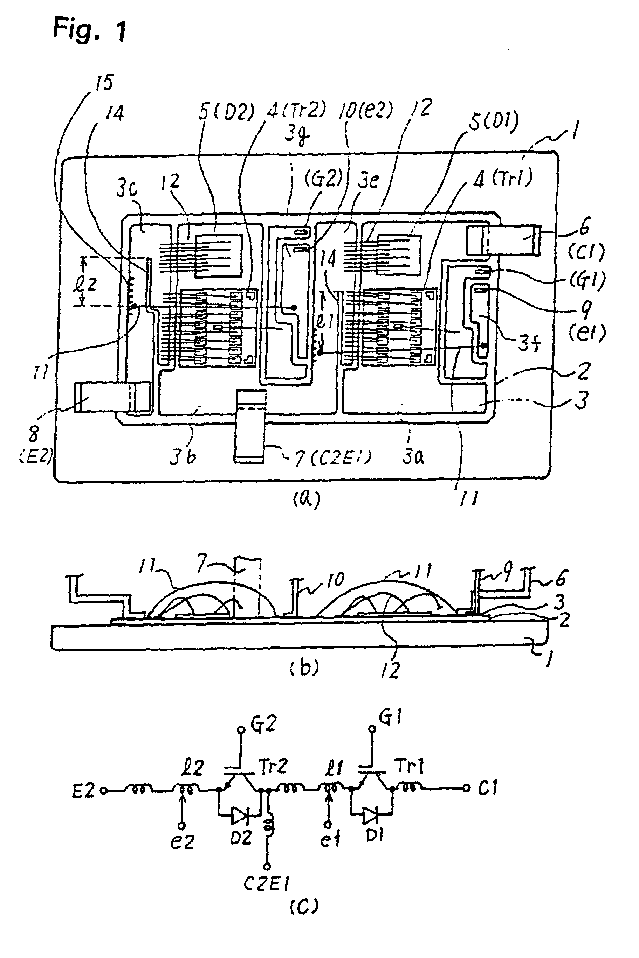

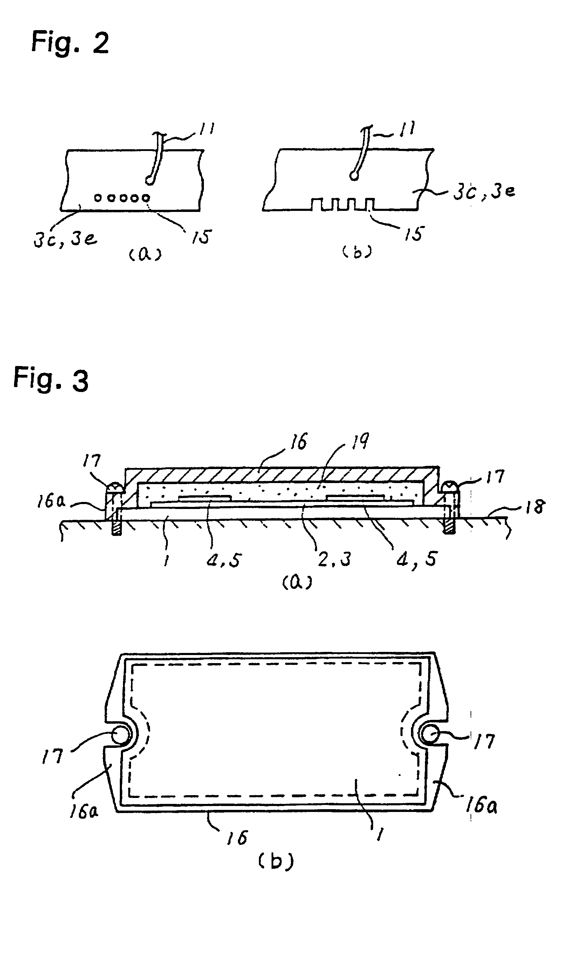

FIG. 1 (a), (b) and (c) and FIG. 2 show an embodiment of the invention. In this embodiment, the transistors Tr1 and Tr2 and the free-wheel diodes D1 and D2 are mounted on the pattern parts 3a and 3b formed separately on the circuit substrate in the same way as in FIG. 5. The external connection terminals 6 (C1) and 7 (C2E1) are taken out from the pattern parts 3a and 3b, respectively, and the external connection terminal 8 (E2) for the transistor Tr2 is connected to the emitter pattern part 3c which is connected to the emitter electrode of the transistor Tr2 and the anode of the diode D2 by bonding wires 12. There is also an emitter pattern part 3e for the transistor Tr1 joined to the chip mounting pattern part 3b for the transistor Tr2 with this pattern part 3e being connected to the emitter electrode of the transistor Tr1 and the anode of the diode D1 by bonding wires 12.

On the other hand, the auxiliary terminals 9 (e1) and 10 (e2) for the transistors Tr1 and Tr2 are taken out from pattern parts 3f and 3g which are formed separately from the aforementioned pattern parts. Moreover, leads 11 (aluminum wires) connect these pattern parts 3f and 3g to wiring inductance regions of the emitter pattern parts 3e and 3c, respectively. As shown in the figure, slits 14 are cut into the emitter pattern parts 3c and 3e such as to form a hairpin shaped (U-shaped) structure for the current paths. Bonding wires 12 taken out from the respective diode and transistor are bonded onto the one side of this hairpin structure. The other side of this hairpin structure is the inductance region which provides an internal wiring inductance of a desired value. By leads 11 these inductance regions are connected to the pattern parts 3f and 3g, respectively. One end of each lead 11 is bonded within the respective inductance region at a position such that wiring inductances I1 and I2 having the desired values are obtained.

Slight changes can be made in the values of the wiring inductances I1 and I2 by shifting the position at which the respective lead 11 is connected along the current paths formed in the pattern parts 3c and 3e. As is shown in the figure, positioning marks 15, which are easy to see, are provided at equal intervals along the inductance regions to indicate experimentally determined positions for the connection of the lead 11. Since such positioning marks can be easily recognized, desired connecting positions for the bonding work can be easily instructed.

Specific examples of these marks 15 are shown in FIG. 2(a) and (b). In FIG. 2(a) equally spaced round holes are formed along the inductance region of the pattern parts 3c and 3e and in FIG. 2(b) equally spaced slits are formed along the edge of the pattern parts 3c and 3e. In both examples the marks are used as indices for indicating or recognizing the bonding position for the lead 11 being bonded.

Providing the wiring inductances I1 and I2 at the emitter pattern part for each of the transistors as in this embodiment has the following benefits. With the kind of construction as in EP-A-0 527 033 mentioned above, where the desired inductances I1 and I2 are provided by an internal connecting member formed at an external connection terminal or as a separate bridge shaped internal connecting member, it is necessary for the shape of the connecting member or the terminal itself to be newly designed and manufactured each time there is a change in the characteristics of the transistors which requires a change in the value of the wiring inductance. This means that no standardized elements can be used even for a systematic production of the power transistor modules. On the contrary, according to the third embodiment, in addition to allowing the same terminals to be used for each of various transistor modules with different specifications, the appropriate internal wiring inductance can be obtained simply by varying the connecting position of the lead on the circuit pattern.

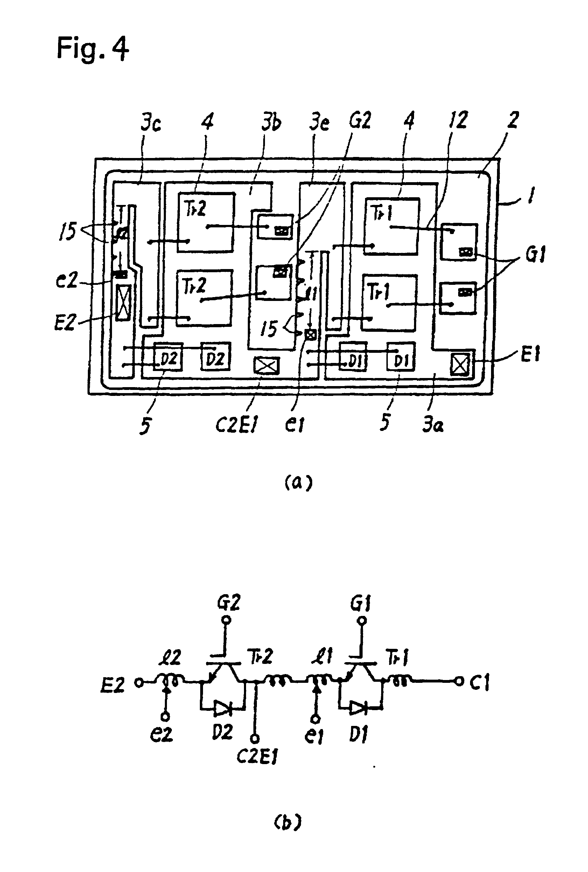

FIG. 4(a) and (b) show a modification of the examples of FIG. 1. In this embodiment, in particular, the external connection terminal E2 for the transistor Tr2 is on the emitter pattern part 3c, and is taken out from a point which is directly adjacent to the auxiliary terminal e2 connected to the inductance region. In this way, as will be seen from a comparison between the equivalent circuits in FIG. 1(c) and FIG. 4(b), the wiring inductance between the external connection terminal E2 and the auxiliary terminal e2 becomes almost zero.

By using this wiring structure, the inductance distribution of the wiring circuits on both sides of the transistor Tr1 in the upper arm is equal to that of the transistor Tr2 in the lower arm . This gives better balance and enhanced stability to the switching characteristics for the transistors Tr1 and Tr2.

A package structure suitable for use with the power transistor modules of each of the embodiments described above is shown in FIG. 3(a) and (b). In these figures, the package is made up of a metal base 1 on which the circuit assembly of each of the embodiments (comprising elements such as the transistors, the free-wheel diodes and external connection terminals) is provided with a circuit substrate between them, and a resin case 16. It is then fixed in place on a heatsink such as a cooling block fin via fixing screws 17 when used. The resin case 16 is then filled up with sealing resin 19 to protect the elements such as the semiconductor chips.

The outer edge of the metal base 1 is laid onto a stepped peripheral edge part 16a of the resin case 16 where it is glued with adhesive. Moreover, slots are formed on both sides of both the metal base 1 and the resin case 16, as can be seen in FIG. 3(b), so that the two members can then be screwed together by screws 17.

In a package with this kind of structure, the bottom of the metal base 1 closely contacts the upper surface of the heatsink 18 when the package of the transistor module is attached to the heatsink 18 with the metal base 1 and the resin case 16 fastened together through the fastening screws 17. Therefore there is no fear that the fitting of the metal base 1 and the resin case 16 will be separated. In addition, as the metal base 1 is required only to have a minimum external dimension necessary for mounting of the internal circuit structure, material can be saved.

With the transistor modules for each of the embodiments described above, a half bridge circuit assembly comprising two power transistor chips Tr1 and Tr2 (or two pairs of power transistor chips) internally connected together in series is incorporated in a single package. However, rather than only one, two or more half bridge circuit assemblies could be incorporated in the same package with each of the half bridge sections connected together internally so as to provide a single phase full bridge or a three phase full bridge circuit made up of, for example, four, or six power transistor modules.

As will be understood by those skilled in the art, although in the embodiments explained above separate free-wheel diode chips are employed these diodes need not be separate components but may for instance be integrated into the power transistor chips.

According to each of the above constructions for the power transistor module, as is shown in the equivalent circuit in FIG. 7, a wiring inductance l1 is connected in series between each of the transistors Tr1 and Tr2, with an auxiliary emitter terminal e1 for the transistor Tr1 being taken out from this inductance l1. According to this internal wiring structure, when the transistor Tr1 is on, the emitter current 1e flows to the load L through the wiring inductance l1. As the transistor Tr1 is turning off, a free-wheeling current If flows from the external connection terminal C2E1 to the load L without flowing through the wiring inductance l1. In this way, as is also the case for the time of the switching operation of the transistor Tr2 on the lower arm side, a counter electromotive force is induced as a result of the current change in the wiring inductance l1. By applying this counter electromotive force to the gate of the transistor Tr1 via the terminal e1, a voltage spike generated upon turning off can be suppressed. It follows that, at the inductance region of the emitter pattern part, by choosing the most appropriate values for the wiring inductances l1 and l2 in accordance with the characteristics of the transistor chips Tr1 and Tr2 and the operating conditions of the switching device, the switching surge which accompanies the switching operation may be suppressed, a more balanced switching operation between the transistors Tr1 and Tr2 may be attained so as to obtain a transistor module with stable switching characteristics.

In this case, the value for the wiring inductances l1 and l2 is in the order of a few nH to 10 nH which may be provided by utilizing the self-inductance of a conducting (copper) bar of the internal connecting member or a circuit pattern for the circuit substrate. The actual effects of the wiring inductance may be confirmed by experiment. In design, however, the inductance value may be calculated from the following equation assuming that the inductance providing member is a thin plate with a rectangular cross section (width a, thickness b, length l):

$$L = 2/3a^2 \times [3a^2 \times l \times \ln(l+(l^2+a^2)^{1/2})/a) - (l^2+a^2)^{3/2} + 3l^2 \times \ln(a+(a^2+l^2)^{1/2})/l)+l^3+a^3] \times 10^{-7}$$

$$- k \times l \times b/a \times 10^{-7} \ [H]$$

where k is an experimental coefficient.

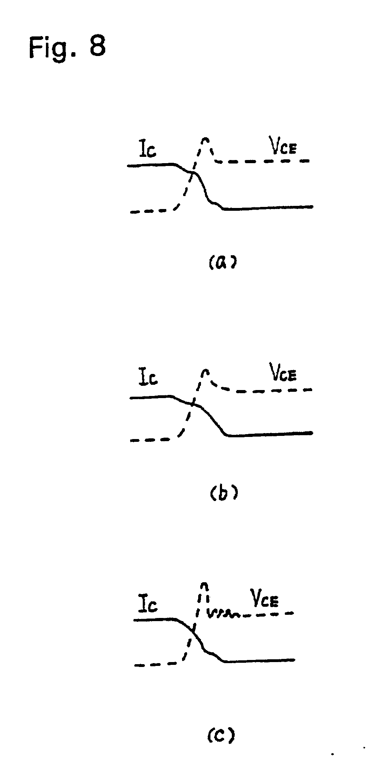

FIG. 8 (a), (b) and (c) illustrate waveforms of the voltage and current in the main circuit during switching. FIG. 8(a) shows the operating waveform for the transistor Tr2 of the lower arm, FIG. 8(b) shows the operating waveform for the transistor Tr1 of the upper arm of the construction in this embodiment, and FIG. 8(c) shows the operating waveform for the transistor Tr1 in the prior art construction shown in FIG. 5. As becomes clear from this diagram, as regards the abrupt switching surge which occurred during the switching operation of the transistor Tr1 in the prior art construction, by adopting the internal wiring structure of the invention, in addition to the switching surge being alleviated, a more balanced switching operation where the operating waveforms for the transistors Tr1 and Tr2 are almost the same is obtained.

## Claims

1. A power transistor module comprising:

   a circuit substrate (2),
   at least one pair of power transistor chips (Tr1, Tr2) mounted on said circuit substrate and each transistor chip having a collector electrode, an emitter electrode and a gate electrode,
   a free-wheel diode (D1, D2) connected in antiparallel to said emitter and collector electrodes of each power transistor chip,
   a circuit pattern (3) on the circuit substrate (2) formed of a plurality of pattern parts separated from each other and comprising a first emitter pattern part (3e), a first collector pattern part (3a) and a first gate pattern part for connection to the emitter electrode, the collector electrode and the gate electrode, respectively, of the first transistor chip (Tr1), a second emitter pattern part (3c), a second collector pattern part (3b) and a second gate pattern part for connection to the emitter electrode, the collector electrode and the gate electrode, respectively, of the second transistor chip (Tr2), and an internal connection pattern part integrally connecting the first emitter pattern part and the second collector pattern part so as to form the upper and lower arms of a bridge circuit, first (C1), second (C2E1) and third (E2) output terminals connected to the first collector pattern part (3a), the second collector pattern part (3b) and the second emitter pattern part (3c), respectively, and first and second gate terminals (G1, G2) connected to the first and second gate pattern parts, respectively,

a first and second auxiliary terminals (e1, e2) taken out from first and second auxiliary pattern parts (3f, 3g), respectively, said first and second auxiliary pattern parts being formed separately from all pattern parts previously defined, said first and second auxiliary terminals (e1, e2) connected to the pattern parts to which said second and third output terminals (C2E1, E2) are connected utilizing a wiring inductance formed by said circuit pattern between the emitter electrode of the first transistor chip and the first auxiliary terminal on the one hand and between the emitter electrode of the second transistor chip and the second auxiliary terminal on the other hand,

said first emitter pattern part (3e) is divided by a slit so as to form a U-shaped structure with a first leg to which the emitter electrode of the first transistor chip (Tr1) is connected and a second leg to which said first auxiliary terminal (e1) is connected, said internal connection pattern part connecting the free end of the second leg to the second collector pattern part (3b), and

said second emitter pattern part (3c) is divided by a slit so as to form a U-shaped structure with a first leg to which the emitter electrode of the second transistor chip (Tr2) is connected and a second leg to which said second auxiliary terminal (e2) is connected, said third output terminal (E2) being connected to the second leg.

2. The module according to claim 1, wherein positioning marks (15) indicating positions for connection of the auxiliary terminal (e1, e2) are provided along the second leg each mark corresponding to another value of said wiring inductance.

3. , The module according to claim 1 or 2, further comprising an auxiliary pattern part (3f, 3g) connected by a lead (11) to the second leg, the auxiliary terminal (e1, e2) being connected to the auxiliary pattern part (3f, 3g).

4. The module according to any one of claims 1 to 3, wherein the connection position for said third external connection terminal (E2) to the second emitter pattern part (3c) is next to the connection position for said second auxiliary terminal (e2).

**Patentansprüche**

1. Leistungstransistormodul, umfassend:

ein Schaltungssubstrat (2),
mindestens ein Paar Leistungstransistorchips (Tr1, Tr2), die auf dem Schaltungssubstrat montiert sind, wobei jeder Transistorchip eine Kollektorelektrode, eine Emitterelektrode und eine Gate-Elektrode aufweist,
eine antiparallel zu der Emitter- und der Kollektorelektrode jedes der Leistungstransistorchips geschaltete Freilaufdiode (D1, D2),
ein Schaltungsmuster (3) auf dem Schaltungssubstrat (2), das aus einer Mehrzahl von gesonderten Musterteilen gebildet ist und umfassend: einen ersten Emittermusterteil (3e), einen ersten Kollektormusterteil (3a) und einen ersten Gate-Musterteil für den Anschluß an die Emitterelektrode, die Kollektorelektrode bzw. die Gate-Elektrode des ersten Transistorchips (Tr1), einen zweiten Emittermusterteil (3c), einen zweiten Kollektormusterteil (3b) und einen zweiten Gate-Musterteil für den Anschluß an die Emitterelektrode, die Kollektorelektrode bzw. die Gate-Elektrode des zweiten Transistorchips (Tr2) sowie einen internen Verbindungsmusterteil, der den ersten Emittermusterteil und den zweiten Kollektormusterteil einstückig verbindet, wodurch der obere und der untere Zweig einer Brückenschaltung gebildet wird,
einen ersten (C1), einen zweiten (C2E1) und einen dritten (E2) Ausgangsanschluß, die mit dem ersten Kollektormusterteil (3a), dem zweiten Kollektormusterteil (3b) bzw. dem zweiten Emittermusterteil (3c) verbunden sind, und einen ersten sowie einen zweiten Gate-Anschluß (G1, G2), die mit dem ersten bzw. dem zweiten Gate-Musterteil verbunden sind,
einen ersten und einen zweiten Hilfsanschluß (e1, e2), die aus einem ersten bzw. einem zweiten Hilfsmusterteil (3f, 3g) herausgeführt sind, wobei der erste und der zweite Hilfsmusterteil gesondert von allen vorgenannten Musterteilen gebildet ist, wobei der erste und der zweite Hilfsanschluß (e1, e2), die mit den Musterteilen verbunden sind, mit denen der zweite und der dritte Ausgangsanschluß (C2E1, E2) verbunden sind, eine Verdrahtungsinduktivität verwendet, die durch das Schaltungsmuster zwischen der Emitterelektrode des ersten Transistorchips und dem ersten Hilfsanschluß einerseits und zwischen der Emitterelektrode des zweiten Transistorchips und dem zweiten Hilfsanschluß andererseits gebildet ist,

wobei der erste Emittermusterteil (3e) durch einen Schlitz so unterteilt ist, daß er eine U-förmige Struktur bildet mit einem ersten Schenkel, mit dem die Emitterelektrode des ersten Transistorchips (Tr1) verbunden ist, und einem zweiten Schenkel, mit dem der erste Hilfsanschluß (e1) verbunden ist, wobei der interne Verbindungsmusterteil das freie Ende des zweiten Schenkels mit dem zweiten Kollektormusterteil (3b) verbindet, und
der zweite Emittermusterteil (3c) durch einen Schlitz so unterteilt ist, daß er eine U-förmige Struktur bildet mit einem ersten Schenkel, mit dem die Emitterelektrode des zweiten Transistorchips (Tr2) verbunden ist, und einem zweiten Schenkel, mit dem der zweite Hilfsanschluß (e2) verbunden ist, wobei der dritte Ausgangsanschluß (E2) mit dem zweiten Schenkel verbunden ist.

2. Modul nach Anspruch 1, bei dem Positionierungsmarkierungen (15), die Positionen für das Anschließen des Hilfsanschlusses (e1, e2) anzeigen, an dem zweiten Schenkel vorgesehen sind, wobei jede Markierung einem anderen Wert der Verdrahtungsinduktivität entspricht.

3. Modul nach Anspruch 1 oder 2, ferner umfassend einen Hilfsmusterteil (3f, 3g), der über einen Draht (11) mit dem zweiten Schenkel verbunden ist, wobei der Hilfsanschluß (e1, e2) mit dem Hilfsmusterteil (3f, 3g) verbunden ist.

4. Modul nach einem der Ansprüche 1 bis 3, bei dem die Position des Anschließens für den dritten externen Verbindungsanschluß (E2) an den zweiten Emittermusterteil (3c) der Position des Anschließens für den zweiten Hilfsanschluß (e2) benachbart ist.

**Revendications**

1. Module de transistor à puissance comportant :

un substrat (2) de circuit,
au moins une paire de puces (Tr1, Tr2) de transistor à puissance montées sur le substrat de circuit et chaque puce de transistor ayant une électrode de collecteur, une électrode d'émetteur et une électrode de grille,
une diode (D1, D2) à roue libre connectée de manière antiparallèle aux électrodes d'émetteur et de collecteur de chaque puce de transistor à puissance,
une configuration (3) de circuit sur le substrat (2) de circuit formée d'une pluralité de parties de configuration séparées les unes des autres et comportant une première partie (3e) de configuration d'émetteur, une première partie (3a) de configuration de collecteur et une première partie de configuration de grille pour la connexion à l'électrode d'émetteur, à l'électrode de collecteur et à l'électrode de grille respectivement de la première puce (Tr1) de transistor, une deuxième partie (3c) de configuration d'émetteur, une deuxième partie (3b) de configuration de collecteur et une deuxième partie de configuration de grille pour une connexion à l'électrode d'émetteur, à l'électrode de collecteur et à l'électrode de grille respectivement de la deuxième puce (Tr2) de transistor, et une partie de configuration de connexion interne connectant intégralement la première partie de configuration d'émetteur et la deuxième partie de configuration de collecteur de manière à former les bras supérieur et inférieur d'un circuit en pont,
des première (C1), deuxième (C2E1) et troisième (E2) bornes de sortie connectées à la première partie (3a) de configuration de collecteur, à la deuxième partie (3b) de configuration de collecteur et à la deuxième partie (3c) de configuration d'émetteur respectivement, et des première et deuxième bornes (G1, G2) de grille connectées aux première et deuxième parties de configuration de grille respectivement,
des première et deuxième bornes (e1, e2) auxiliaires qui sortent des première et deuxième parties (3f, 3g) de configuration auxiliaires respectivement, les première et deuxième parties de configuration auxiliaires étant formées séparément à partir de toutes les parties de configuration précédemment définies, les première et deuxième bornes (e1, e2) auxiliaires étant connectées aux parties de configuration auxquelles les deuxième et troisièmes bornes (C2E1, E2) de sortie sont connectées en utilisant une inductance de câblage formée par la configuration de circuit entre l'électrode d'émetteur de la première puce de transistor et la première borne auxiliaire, d'une part, et entre l'électrode d'émetteur de la deuxième puce de transistor et la deuxième borne auxiliaire, d'autre part,
la première partie (3e) de configuration d'émetteur étant divisée par une fente de manière à former une structure en forme de U avec un premier jambage auquel l'électrode d'émetteur de la première puce (Tr1) de transistor est connectée et un deuxième jambage auquel la première borne (e1) auxiliaire est connectée, la partie de configuration de connexion intérieure connectant l'extrémité libre du deuxième jambage à la deuxième partie (3b) de configuration de collecteur, et

la deuxième partie (3c) de configuration d'émetteur est divisée par une fente de manière à former une structure en forme de U avec un premier jambage auquel l'électrode d'émetteur de la deuxième puce (Tr2) de transistor est connectée et un deuxième jambage auquel la deuxième borne (e2) auxiliaire est connectée, la troisième borne (E2) de sortie étant connectée au deuxième jambage.

2. Module suivant la revendication 1, dans lequel des repères (15) de positionnement indiquant des positions pour la connexion des bornes (e1, e2) auxiliaires sont disposés le long du deuxième jambage, chaque repère correspondant à une autre valeur de l'inductance de câblage.

3. Module suivant la revendication 1 ou 2, comportant en outre une partie (3f, 3g) de configuration auxiliaire connectée par un conducteur (11) au deuxième jambage, les bornes (e1, e2) auxiliaires étant connectées à la partie (3f, 3g) de configuration auxiliaire.

4. Module suivant l'une quelconque des revendications 1 à 3, dans lequel la position de connexion pour la troisième borne (E2) de connexion extérieure à la deuxième partie (3c) de configuration d'émetteur est proche de la position de connexion pour la deuxième borne (e2) auxiliaire.

# Fig. 1

(a)

(b)

(C)

Fig. 2

Fig. 3

Fig. 4

(a)

(b)

# Fig. 5

(a)

(b)

## Fig. 6

## Fig. 7

Fig. 8

(a)

(b)

(c)